(19) **Europäisches Patentamt / European Patent Office / Office européen des brevets**

(11) **EP 1 384 312 B1**

(12) **EUROPEAN PATENT SPECIFICATION**

(45) Date of publication and mention
of the grant of the patent:
**26.11.2008 Bulletin 2008/48**

(21) Application number: **02718443.1**

(22) Date of filing: **08.04.2002**

(51) Int Cl.:
***H03B 5/12*** *(2006.01)*

(86) International application number:
**PCT/IB2002/001107**

(87) International publication number:
**WO 2002/084857 (24.10.2002 Gazette 2002/43)**

(54) **TUNABLE VOLTAGE CONTROLLED OSCILLATOR**

ABSTIMMBARER SPANNUNGSGESTEUERTER OSZILLATOR

OSCILLATEUR COMMANDE EN TENSION ACCORDABLE

(84) Designated Contracting States:
**AT BE CH CY DE DK ES FI FR GB GR IE IT LI LU MC NL PT SE TR**

(30) Priority: **11.04.2001 US 283093 P
13.07.2001 US 904631
24.07.2001 US 912753
08.08.2001 US 927732
10.08.2001 US 927136**

(43) Date of publication of application:
**28.01.2004 Bulletin 2004/05**

(73) Proprietor: **Kyocera Wireless Corp.
San Diego, CA 92121 (US)**

(72) Inventors:
• **TONCICH, Stanley, S.
San Diego, CA 92131 (US)**
• **FORRESTER, Timothy
San Diego, CA 92131 (US)**

(74) Representative: **Viering, Jentschura & Partner
Postfach 22 14 43
80504 München (DE)**

(56) References cited:
**EP-A- 0 125 586    EP-A- 0 854 567
EP-A- 1 043 741    WO-A1-82/03510
DE-A- 4 036 866    US-A- 4 494 081
US-A- 4 736 169    US-A- 5 600 279**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

### Field of the Invention

The present invention relates generally to tunable electronic devices and components and, more particularly, to band-switchable voltage controlled oscillators incorporating tunable ferroelectric components.

### Background of the Invention

Radio frequency bandwidth is a scarce resource that is highly valued and is becoming increasingly congested. Ever-increasing numbers of users are attempting to co-exist and to pass ever-increasing amounts of information through the finite amount of bandwidth that is available. The radio spectrum is divided into frequency bands that are allocated for specific uses. In the United States, for example, all FM radio stations transmit in the 88-108 MHz band and all AM radio stations transmit in the 535 kHz-1.7 MHz band. The frequency band around 900 MHz is reserved for wireless phone transmissions. A frequency band centered around 2.45 GHz has been set aside for the new Bluetooth technology. Hundreds of other wireless technologies have their own band of the radio spectrum set aside, from baby monitors to deep space communications.

Communications within a given frequency band occur on even more narrowly and precisely defmed channels within that band. Hence, in virtually any wireless communication system or device, frequency agility is required and accurate frequency generation is of critical importance. Frequency generation is typically provided by an electronic oscillator. As is well known in the art, an electronic oscillator is a circuit that produces an output signal of a specific frequency, and consists generally of an amplifier having part of its output returned to the input by means of a feedback loop. A very simple electronic oscillator includes some combination of a capacitor with an inductor or other resonator.

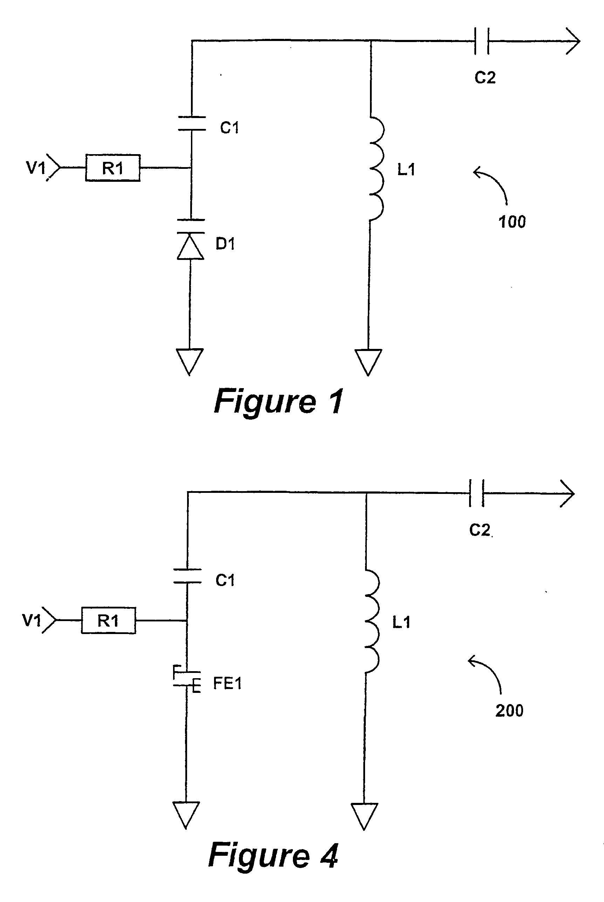

The capacity for frequency channel selection and changing can be provided by a voltage controlled oscillator ("VCO"). In a VCO, a control voltage is applied to a voltage dependent capacitor, commonly referred to as a variable capacitance diode, varicap diode or varactor, in order to tune the VCO to a particular frequency. **Figure 1** illustrates a conventional varicap diode tuned oscillator resonant circuit 100. Circuit 100 includes varicap diode D1 and resonator L1 (L1 is an inductor or some other form of resonant transmission line device). Control voltage V1 is applied across varicap diode D1 via input resistance R1. V1 is a DC control voltage and is applied to tune the oscillator over a specified range. DC blocking capacitor C1 is interposed between varicap diode D1 and inductor L1, and DC blocking capacitor C2 is interposed between inductor L1 and an oscillator sustaining amplifier (not shown). Typically, the sustaining amplifier is a negative impedance generator. As is well known in the art, phase-locked loop (PLL) control circuitry will also typically be provided in conjunction with the VCO.

When a reverse voltage (V1) is applied to varicap diode D1, the insulation layer between the p-doped and n-doped regions of the semiconductor thickens. A depletion region that is essentially devoid of carriers forms in diode D1, and behaves as the dielectric of the capacitor. The depletion region increases as the reverse voltage across it increases, and since capacitance varies inversely as dielectric thickness, the junction capacitance decreases as the reverse voltage increases. The effect is similar to separating the two plates of a capacitor by a larger distance, which decreases the capacitance. So, by varying the control voltage V1 the junction capacitance provided by varicap diode D1 can be varied. Varying the capacitance, in turn, changes the resonant frequency of inductor L1 and hence the frequency that will be amplified and output by circuit 100.

In recent years, VCO designers have been required to comply with significantly more demanding specifications. Currently, only a handful of manufacturers world wide can economically produce VCOs that are suitable for use in high volume consumer communication devices. Two of the major hurdles faced in VCO design are (1) phase noise and (2) the inherent non-linear transfer function (applied voltage versus capacitance) of varicap diodes.

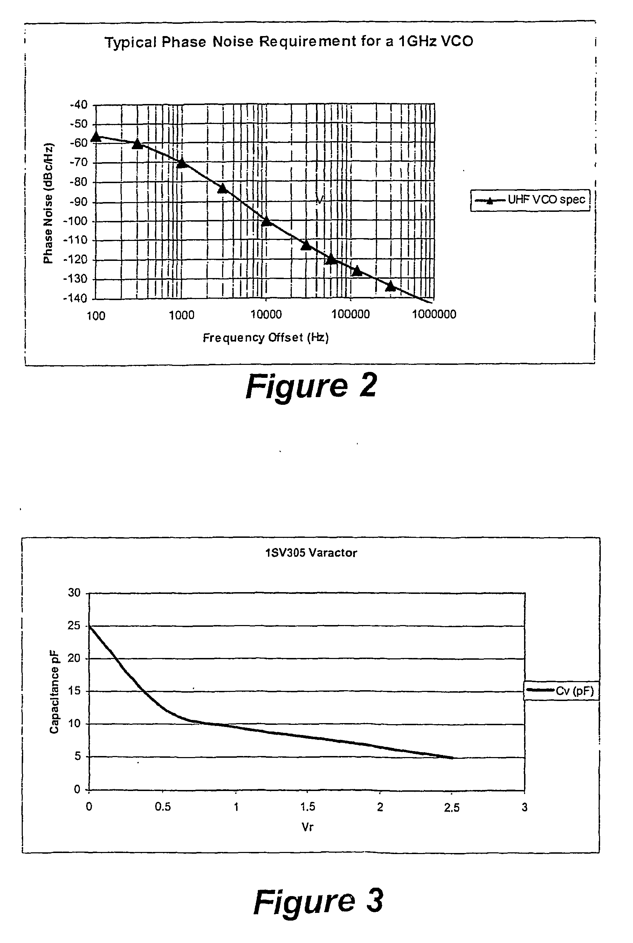

One critical parameter of oscillator performance is its single sideband phase noise, or simply "phase noise". Phase noise affects the receiver's ability to reject unwanted signals on nearby channels. It is the ratio of the output power divided by the noise power at a specified offset and is expressed in dBc/Hz. **Figure 2** is a graph showing the typical phase noise requirement for a 1 GHz VCO. As can be seen, at an offset of about 60 kHz a 1 GHz oscillator specifies a phase noise of about -120dBc/Hz.

One of the main stumbling blocks to achieving this performance is the loaded Q of the oscillator circuit. The sustaining amplifier of the oscillator does not usually play a significant factor in phase noise determination due to the availability of low noise semiconductors that are specifically optimized for this purpose. The loaded Q of the resonator structure (L1) is typically the dominant factor in determining the overall phase noise performance. The loaded Q of the resonator is frequently limited by the series resistance of the varicap diode, which can be as much as several ohms.

The Q of a capacitor can be expressed by:

$Q = X_c/R_s$, where $X_c$ is the reactance of the varicap diode given by

$$X_c = 1/(2 \cdot \pi \cdot f \cdot c),$$

and $R_s$ is the effective series resistance of the varicap diode.

If a required capacitance of 5 pF at a frequency of 1.5 GHz is assumed, a reactance $X_c$ of 21.22Ω results. If it is further assumed that the effective series resistance $R_s$ of the varicap diode is 0.5Ω, the resultant Q of the varicap diode is 42.44. Hence, reducing the effective series resistance will have a direct impact on the Q of the varicap diode and the loaded Q of the entire resonator structure.

Another critical parameter in oscillator performance is the linearity (or lack thereof) in the transfer function (applied voltage versus capacitance) of the varicap diode. **Figure 3** is a chart plotting the capacitance of a typical varicap diode versus a typical tuning voltage range for the diode in a mobile phone (0.3V to 2.7V). As can be seen, it is not a linear relation. Below 0.5V, unit voltage changes lead to much greater unit capacitance changes. Consequently, the MHz/volt frequency shift of the oscillator is not constant across the tuning range. This leads to compromise in the design of the PLL loop filter and thus overall noise performance.

Another problem associated with the use of varicap diodes is that, since it is a reverse-biased diode junction, it is important that the applied AC signal does not overcome the bias voltage and result in heavy forward conduction of the diode. If this occurs the Q of the resonator will be dramatically lowered and various oscillator parameters such as phase noise and general spectral purity will be seriously impacted. In an extreme case, the oscillator may fail to maintain a continuous oscillation and degenerate into parasitic uncontrolled burst oscillations.

In view of the above, there is a need for a voltage controlled oscillator that exhibits better phase noise performance and a more linear voltage/capacitance transfer function.

US 4494081 discloses a band-switchable oscillator using a parallel resonant LC circuit comprising two series-connected varactor diodes. A control voltage is applied to the junction of the two varactors and band-switching is possible by setting a proportion of the control voltage to be applied to the other terminal of one of the varactors.

## Summary of the Invention

An embodiment of the invention comprises a band-switchable oscillator resonant circuit. The circuit has first and second ferroelectric capacitors and first and second control voltage lines to facilitate band switching.

In another embodiment, there is provided a method for band switching in a voltage controlled oscillator. First and second ferroelectric capacitors are provided, and first and second control voltages are applied to the first and second capacitors so that either the first capacitor or the second capacitor dominates the output frequency of the oscillator.

Other features, objects and implementations of the invention will be or will become apparent to one with skill in the art upon examination of the following figures and detailed description. Such additional features are intended to be included within the scope of the invention insofar as they are covered by the accompanying claims.

## Brief Description of the Drawings

**Figure 1** is a schematic of a conventional varicap diode tuned oscillator resonant circuit.

**Figure 2** is a graph plotting phase noise versus frequency offset requirements for a typical 1 GHz voltage controlled oscillator.

**Figure 3** is a graph plotting capacitance versus applied control voltage for a typical varicap diode.

**Figure 4** is a schematic of a ferroelectric tuned oscillator resonant circuit that does not form part of the invention.

**Figure 5** is a graph plotting capacitance versus applied control voltage for a ferroelectric capacitor.

**Figure 6** is a schematic of a ferroelectric tuned oscillator circuit with adaptive feedback that is not according to the invention.

**Figure 7** is a schematic of a band-switchable ferroelectric tuned oscillator resonant circuit according to the present invention.

## Detailed Description of the Invention

VCOs currently in use typically employ a varicap diode as a frequency tuning device. These VCOs exhibit compromised phase noise performance and a non-linear capacitance/control voltage transfer function. In order to overcome these shortcomings, the present invention provides a voltage controlled oscillator employing ferroelectric capacitors, rather than a varicap diodes, as the tuning devices.

The background, advantages, topologies and test methods associated with ferroelectric capacitors are fully set forth in commonly owned United States provisional application serial no. 60/283,093 filed on April 11, 2001, as well as commonly owned related application nos. 09/904,631; 09/912,753; 09/927,732; 09/927,136; 10/044,522; 10/077,654; 10/076,171; 10/075,896; 10/075,727; and 10/075,507. Briefly, these applications disclose test methods utilizing narrowband resonant circuits that accurately measure and characterize the loss due to use of a ferroelectric material, and establish that ferroelectric components are not as lossy as previously thought. Previous testing methods and devices did not account for all loss mechanisms and it was therefore not possible to accurately determine the loss due to use of ferroelectric material. In one implementation, the narrowband resonant circuit used for testing is a microstrip resonator having a gap to define the capacitor, and a ferroelectric film deposited in the gap.

By employing proper testing methods and loss accounting mechanisms, tunable ferroelectric components can be optimized and designed for use in a wide variety of low loss applications and frequency agile circuits. The choice of topology is critical for attaining the best possible Q (lowest losses). Depending on the particular topology and materials that are employed, and the applicable frequency range, Qs of greater than 80, greater than 180 and even higher are attainable. Design procedures and implementation details are set forth for gap capacitors, overlay capacitors and interdigital capacitors. The lowest losses are achieved by direct fabrication of the ferroelectric capacitor to the resonator or other RF circuitry. This eliminates added losses caused by attachment of the ferroelectric capacitor to a circuit.

**Figure 4** depicts a ferroelectric tuned oscillator resonant circuit 200 that is not according to the invention. VCO 200 is similar to VCO 100 depicted in **Figure 1**, but utilizes a ferroelectric capacitor FE1 rather than a varicap diode Dl. Ferroelectric capacitor FE1 is constructed, tested and integrated into circuit 200 as described in the applications noted above. L1 is an inductor or other resonant transmission line device. The output of circuit 200 leads to an oscillator sustaining amplifier (not shown).

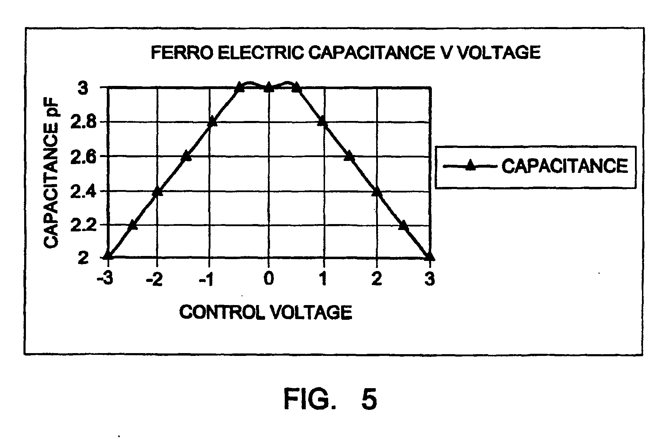

A variable ferroelectric capacitor has several advantages over a varicap diode. First, it has a much lower series resistance, typically by a factor of ten. This will directly result in a higher loaded Q (Q= $X_C$ / $R_S$ see discussion above) and better phase noise performance. Secondly, as plotted in **Figure 5**, the capacitance/applied voltage transfer function of a ferroelectric capacitor is essentially linear, thereby permitting the design of more optimum PLL loop filters. Finally, ferroelectric capacitors do not suffer from the forward bias conduction problems of varicap diodes. This final aspect permits the design of novel band-switching oscillators, as will be described below.

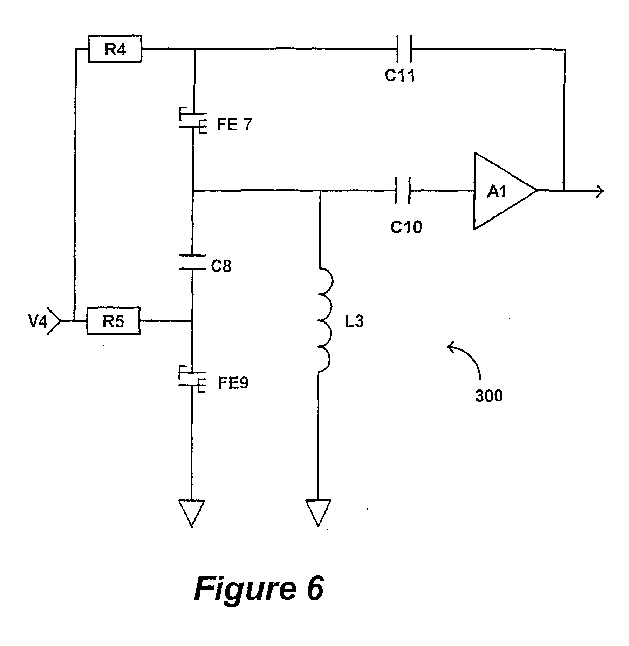

In addition to setting the desired operating frequency, it is also possible to use a combination of ferroelectric variable capacitors to adjust the oscillation sustaining feedback path. This further example not forming part of the invention is illustrated in Figure 6. By simultaneously adjusting the level of feedback in conjunction with changing the frequency, the performance of the oscillator is maintained over a wider bandwidth. A conventional oscillator, such as the oscillator depicted in Figure 1, has an optimum operating frequency where its output is at its best performance, in terms of spectral purity and RF power. This is sometimes described as the oscillator's "sweet spot". Maintaining this optimum feedback is important, especially for oscillator designs that are required to tune across a wide bandwidth (greater than fifteen percent of the oscillator center frequency). As the oscillator is tuned away from its sweet spot and moves towards its limits of tuning, however, the RF output power frequently drops and the phase noise (or spectral purity) is degraded.

As illustrated in Figure 6, it is possible to use a second ferroelectric component to maintain optimum performance across a wider bandwidth by varying the feedback parameters with the desired operating frequency. In order for oscillator 300 to produce a comparatively spectrally pure signal, the open loop peak gain of the oscillator must correspond to the zero phase shift point around the entire loop. A failure to maintain this relationship across the tuning range will lead to degraded oscillator performance. In an extreme case, the oscillator may stop oscillating.

In circuit 300 of Figure 6, FE7 and FE9 are ferroelectric variable capacitors. Capacitor C8 is a DC blocking capacitor; but could also optionally be a ferroelectric capacitor. Capacitors C10 and C11 are DC blocking capacitors. In operation, control voltage V4 is used to vary the capacitance of ferroelectric capacitor FE9. The capacitance of capacitor FE9, in conjunction with the other components (primarily capacitor C8 and inductor L3) sets the oscillator frequency that is output by amplifier Al. Varying control voltage V4 therefore proportionally varies the oscillator frequency. Control voltage V4, in addition, controls the DC potential across ferroelectric capacitor FE7. Hence, the capacitance of FE7 also varies with the applied control voltage. By careful design and selection of capacitors C7, C10 and C11, the amplitude and phase of the feedback signal is accurately controlled at the desired frequency, thereby maintaining optimum performance.

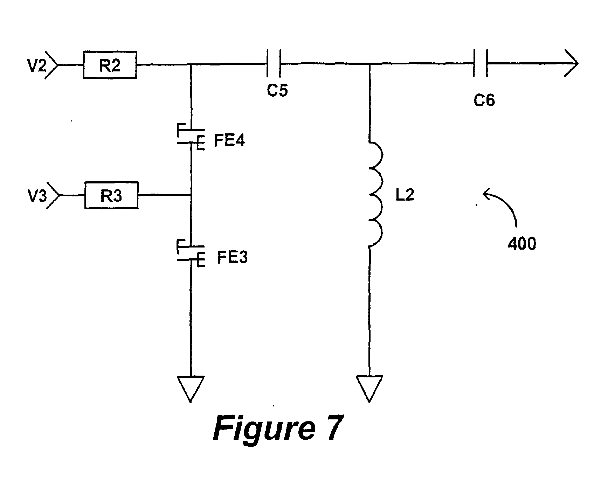

The embodiment of the invention, illustrated in Figure 7, utilizes ferroelectric capacitors to provide a novel band-switching oscillator 400. Circuit 400 can be configured in a number of ways to provide effective band-switching or to affect the available tuning range. Capacitors FE3 and FE4 are ferroelectric components, and capacitors C5 and C6 are DC blocking capacitors. The output line from capacitor C6 leads to the oscillator sustaining amplifier (not shown).

Circuit 400 has two control voltage Inputs: V2 and V3. The frequency of oscillation produced by circuit 400 can be affected by varying control voltages V2 and V3 either together or independently. Multiple scenarios are possible. In a first scenario, a single (the same) control voltage is applied to both V2 and V3. This makes the control voltage across capacitor FE4 effectively zero, thereby setting its capacitance to its maximum value. Thus, the voltage across FE3 and hence its capacitance effectively dominate the frequency setting. In a second scenario, control input V3 is grounded and a control voltage is applied to V2. In this scenario, there is no potential difference across FE3 and its capacitance therefore is set to its maximum value. The voltage across FE4 and hence its capacitance effectively dominate the frequency setting. Hence, by choosing different capacitance ranges for FE4 and FE3, effective band-switching can be provided by setting the control voltages as described in the first and second scenarios.

In a third scenario, a control voltage is applied to V3 and control voltage V2 is grounded. In this scenario, both FE3 and FE4 experience the same DC control voltage and thus shift in capacitance. From an AC aspect, the capacitors are effectively in series, thereby significantly increasing the operating frequency and permitting coverage of other communication bands. Similar results may be obtained by applying different control voltages to V2 and V3.

Other embodiments and implementations of the invention will be or will become apparent to one with skill in the art. Such additional embodiments and implementations are intended to be within the scope of the invention insofar as they are protected by the accompanying claims.

## Claims

1. A band switchable voltage controlled oscillator (400) having a resonant circuit, wherein the resonant circuit is **characterized by**
   an inductive element (L2) connected between a ground and a first terminal of a DC blocking capacitor (C5);
   a first ferroelectric capacitor (FE3) connected in series with a second ferroelectric capacitor (FE4), wherein the series first and second capacitors (FE3, FE4) are connected between the ground and a second terminal of the DC blocking capacitor (C5);
   a first control voltage line (V3) connected through a first resistance (R3) to a second terminal of the second ferroelectric capacitor (FE4) and a first terminal of the first ferroelectric capacitor (FE3), and wherein a second terminal of the first ferroelectric capacitor is connected to the ground;
   a second control voltage line (V2) connected through a second resistance (R2) to the second terminal of the blocking capacitor (C5) and a first terminal of the second ferroelectric capacitor (FE4);
   wherein an output frequency of the oscillator (400) is within a first frequency band when the same control voltage is applied to the first and second control coltage lines (V2, V3); and
   wherein an output frequency of the oscillator (400) is within a second frequency band when 0 V is aplied to the first control voltage line (V3) and a second voltage is applied to the second control voltage line (V2).

2. The oscillator as claimed in claim 1, wherein the first control voltage (V3) has a linear relation to the first capacitance of the first ferroelectric capacitor (FE3) across the first frequency band.

3. The oscillator as claimed in claim 1, wherein the second control voltage (V2) has a linear relation to the second capacitance of the first ferroelectric capacitor (FE3) across the first frequency band.

4. A method for band switching in a voltage controlled oscillator (400), comprising:

   providing a resonant circuit comprising a first ferroelectric capacitor (FE3) and a second ferroelectric capacitor (FE4) connected in series between a first terminal of a blocking capacitor (C5) and a ground, the resonant circuit further comprising an inductive element (L2) connected between a second terminal of the blocking capacitor (C5) and the ground; and
   applying a first control voltage (V3) and a second control voltage (V2) to the first and second ferroelectric capacitors (FE3, FE4) so that the resonant circuit resonates in one of a first frequency band corresponding to the first ferroelectric capacitor (FE3), or in a second frequency band corresponding to the second ferroelectric capacitor (FE4);

   wherein the first control voltage (V3) is coupled through a first resistance (R3) to a first terminal of the first ferroelectric capacitor (FE3) and to a second terminal of the second ferroelectric capacitor (FE4), and wherein the second control voltage (V2) is coupled through a second resistance (R2) to a first terminal of the second ferroelectric capacitor (FE4), and wherein a second terminal of the first ferroelectric capacitor (FE3) is coupled to the ground;
   wherein when the first control voltage (V3) and the second control voltage (V2) are approximately the same, causing the voltage across the second ferroelectric capacitor (FE4) to be effectively zero, the resonant circuit is caused to resonate in the first frequency band corresponding to the first ferroelectric capacitor (FE3), and when the first control voltage (V3) is grounded and the second control voltage (V2) is not grounded, causing the voltage across the first ferroelectric capacitor (FE3) to be effectively zero, the resonant circuit is caused to resonate in the second frequency band corresponding to the second ferroelectric capacitor (FE4).

## Patentansprüche

1. Band-umschaltbarer spannungsgesteuerter Oszillator (400) mit einem Resonanzschaltkreis, wobei der Resonanzschaltkreis **gekennzeichnet ist durch**
   ein induktives Element (L2), das zwischen einer Erdung und einem ersten Endgerät eines Gleichstrom-Blockkondensators (C5) gekoppelt ist,
   einen ersten ferroelektrischen Kondensator (FE3), der mit einem zweiten ferroelektrischen Kondensator (FE4) in Reihe geschaltet ist, wobei die Reihe des ersten Kondensators und des zweiten Kondensators (FE3, FE4) zwischen der Erdung und einem zweiten Endgerät des Gleichstrom-Blockkondensators (C5) geschaltet ist,

eine erste Steuerspannungsleitung (V3), die mittels eines ersten Widerstands (R3) mit einem zweiten Endgerät des zweiten ferroelektrischen Kondensators (FE4) und einem ersten Endgerät des ersten ferroelektrischen Kondensators (FE3) gekoppelt ist, und wobei ein zweites Endgerät des ersten ferroelektrischen Kondensators mit der Erdung gekoppelt ist,

eine zweite Steuerspannungsleitung (V2), die mittels eines zweiten Widerstands (R2) mit dem zweiten Endgerät des Blockkondensators (C5) und einem ersten Endgerät des zweiten ferroelektrischen Kondensators (FE4) gekoppelt ist,

wobei eine Ausgangsfrequenz des Oszillators (400) innerhalb eines ersten Frequenzbandes liegt, wenn dieselbe Steuerspannung an die erste Steuerspannungsleitung und die zweite Steuerspannungsleitung (V2, V3) angelegt wird, und

wobei eine Ausgangsfrequenz des Oszillators (400) innerhalb eines zweiten Frequenzbandes liegt, wenn 0 V an die erste Steuerspannungsleitung (V3) angelegt wird und eine zweite Spannung an die zweite Steuerspannungsleitung (V2) angelegt wird.

2. Oszillator gemäß Anspruch 1, wobei die erste Steuerspannung (V3) ein lineares Verhältnis zu der ersten Kapazität des ersten ferroelektrischen Kondensators (FE3) über das erste Frequenzband hat.

3. Oszillator gemäß Anspruch 1, wobei die zweite Steuerspannung (V2) ein lineares Verhältnis zu der zweiten Kapazität des ersten ferroelektrischen Kondensators (FE3) über das erste Frequenzband hat.

4. Verfahren zum Band-Umschalten in einem spannungsgesteuerten Oszillator (400), aufweisend:

Bereitstellen eines Resonanzschaltkreises, der einen ersten ferroelektrischen Kondensator (FE3) und einen zweiten ferroelektrischen Kondensator (FE4) aufweist, die zwischen einem ersten Endgerät eines Blockkondensators (C5) und einer Erdung in Reihe geschaltet sind, wobei der Resonanzschaltkreis ferner ein induktives Element (L2) aufweist, das zwischen einem zweiten Endgerät des Blockkondensators (C5) und der Erdung gekoppelt ist, und

Anlegen einer ersten Steuerspannung (V3) und einer zweiten Steuerspannung (V2) an den ersten ferroelektrischen Kondensator und den zweiten ferroelektrischen Kondensator (FE3, FE4), so dass der Resonanzschaltkreis in einem von einem ersten Frequenzband, das dem ersten ferroelektrischen Kondensator (FE3) entspricht oder in einem zweiten Frequenzband, das dem zweiten ferroelektrischen Kondensator (FE4) entspricht, mitschwingt,

wobei die erste Steuerspannung (V3) mittels eines ersten Widerstands (R3) mit einem ersten Endgerät des ersten ferroelektrischen Kondensators (FE3) und mit einem zweiten Endgerät des zweiten ferroelektrischen Kondensators (FE4) gekoppelt ist, und wobei die zweite Steuerspannung (V2) mittels eines zweiten Widerstands (R2) mit einem ersten Endgerät des zweiten ferroelektrischen Kondensators (FE4) gekoppelt ist, und wobei ein zweites Endgerät des ersten ferroelektrischen Kondensators (FE3) mit der Erdung gekoppelt ist,

wobei, wenn die erste Steuerspannung (V3) und die zweite Steuerspannung (V2) ungefähr gleich sind, wodurch bewirkt wird, dass die Spannung an dem den zweiten ferroelektrischen Kondensator (FE4) effektiv Null beträgt, dann bewirkt wird, dass der Resonanzschaltkreis in dem ersten Frequenzband entsprechend dem ersten ferroelektrischen Kondensator (FE3) mitschwingt, und, wenn die erste Steuerspannung (V3) geerdet ist und die zweite Steuerspannung (V2) nicht geerdet ist, wodurch bewirkt wird, dass die Spannung an dem ersten ferroelektrischen Kondensator (FE3) effektiv Null ist, dann bewirkt wird, dass der Resonanzschaltkreis in dem zweiten Frequenzband entsprechend dem zweiten ferroelektrischen Kondensator (FE4) mitschwingt.

## Revendications

1. Oscillateur commandé en tension à commutation de bandes (400) ayant un circuit résonnant, dans lequel le circuit résonnant est **caractérisé par**

un élément inductif (L2) relié entre la masse et une première borne d'un condensateur de blocage de CC (C5) ;

un premier condensateur ferroélectrique (FE3) relié en série à un deuxième condensateur ferroélectrique (FE4), où les premier et deuxième condensateurs en série (FE3, FE4) sont reliés entre la masse et une deuxième borne du condensateur de blocage de CC (C5) ;

une première ligne de tension de commande (V3) reliée par une première résistance (R3) à une deuxième borne du deuxième condensateur ferroélectrique (FE4) et une première borne du premier condensateur ferroélectrique (FE3), et où une deuxième borne du premier condensateur ferroélectrique est reliée à la masse ;

une deuxième ligne de tension de commande (V2) reliée par une deuxième résistance (R2) à la deuxième borne du condensateur de blocage (C5) et une première borne du deuxième condensateur ferroélectrique (FE4) ;

où une fréquence de sortie de l'oscillateur (400) est comprise dans une première bande de fréquences lorsque la même tension de commande est appliquée aux première et deuxième lignes de tension de commande (V2, V3) ; et où une fréquence de sortie de l'oscillateur (400) est comprise dans une deuxième bande de fréquences lorsque 0 V est appliqué à la première ligne de tension de commande (V3) et une deuxième tension est appliquée à la deuxième ligne de tension de commande (V2).

2.  Oscillateur selon la revendication 1, dans lequel la première tension de commande (V3) a une relation linéaire avec la première capacité du premier condensateur ferroélectrique (FE3) à travers la première bande de fréquences.

3.  Oscillateur selon la revendication 1, dans lequel la deuxième tension de commande (V2) a une relation linéaire avec la deuxième capacité du premier condensateur ferroélectrique (FE3) à travers la première bande de fréquences.

4.  Procédé de commutation de bandes dans un oscillateur commandé en tension (400), consistant à :

    fournir un circuit résonnant comprenant un premier condensateur ferroélectrique (FE3) et un deuxième condensateur ferroélectrique (FE4) reliés en série entre une première borne d'un condensateur de blocage (C5) et une masse, le circuit résonnant comprenant en outre un élément inductif (L2) relié entre une deuxième borne du condensateur de blocage (C5) et la masse ; et appliquer une première tension de commande (V3) et une deuxième tension de commande (V2) aux premier et deuxième condensateurs ferroélectriques (FE3, FE4) de sorte que le circuit résonnant résonne dans l'une parmi une première bande de fréquences correspondant au premier condensateur ferroélectrique (FE3), ou dans une deuxième bande de fréquences correspondant au deuxième condensateur ferroélectrique (FE4) ;

    où la première tension de commande (V3) est couplée par une première résistance (R3) à une première borne du premier condensateur ferroélectrique (FE3) et à une deuxième borne du deuxième condensateur ferroélectrique (FE4), et où la deuxième tension de commande (V2) est couplée par une deuxième résistance (R2) à une première borne du deuxième condensateur ferroélectrique (FE4), et où une deuxième borne du premier condensateur ferroélectrique (FE3) est couplée à la masse ; où lorsque la première tension de commande (V3) et la deuxième tension de commande (V2) sont approximativement égales, conduisant la tension à travers le deuxième condensateur ferroélectrique (FE4) à être effectivement égale à zéro, le circuit résonnant est amené à résonner dans la première bande de fréquences correspondant au premier condensateur ferroélectrique (FE3), et lorsque la première tension de commande (V3) est mise à la masse et la deuxième tension de commande (V2) n'est pas mise à la masse, conduisant la tension à travers le premier condensateur ferroélectrique (FE3) à être effectivement égale à zéro, le circuit résonnant est amené à résonner dans la deuxième bande de fréquences correspondant au deuxième condensateur ferroélectrique (FE4).

**Figure 1**

**Figure 4**

**Figure 2**

**Figure 3**

FERRO ELECTRIC CAPACITANCE V VOLTAGE

FIG. 5

*Figure 6*

**Figure 7**

**EP 1 384 312 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4494081 A
- US 60283093 B
- US 09904631 B
- US 09912753 B
- US 09927732 B
- US 09927136 B
- US 10044522 B
- US 10077654 B
- US 10076171 B
- US 10075896 B
- US 10075727 B
- US 10075507 B